# EUROPÄISCHE PATENTSCHRIFT

(11) **EP 0 806 674 B1**
(45) Veröffentlichungstag und Bekanntmachung des Hinweises auf die Patenterteilung: **08.11.2000**
(21) Anmeldenummer: 97106546.1
(22) Anmeldetag: 21.04.1997
(51) Int. Cl.: G01R 15/18, G01R 19/20, H01F 38/28

(54) **Stromkompensierter Stromsensor**
Current compensated current sensor
Capteur de courant à compensation du courant

(30) Priorität: 06.05.1996 DE 19618114
(43) Veröffentlichungstag der Anmeldung: 12.11.1997
(73) Patentinhaber: Vacuumschmelze GmbH, 63450 Hanau (DE)
(72) Erfinder: Lenhard, Friedrich, 63452 Hanau (DE)
(74) Vertreter: Patentanwälte Westphal, Mussgnug & Partner

(56) Entgegenhaltungen:
- EP-A- 0 314 234
- EP-A- 0 427 412
- WO-A-96/20408
- DE-A- 3 443 460
- DE-A- 4 019 810
- DE-A- 4 130 999
- DE-A- 4 229 948
- DE-U- 29 507 675
- US-A- 4 314 200
- US-A- 4 325 096
- US-A- 5 508 606
- ELECTRONIC COMPONENTS AND APPLICATIONS, Bd. 3, Nr. 2, 1981, Seiten 101-109, XP002037230 J.A.HOULDSWORTH: "Purpose-designed ferrite toroids for isolated current measurement in power electronic equipment"
- IEEE TRANSACTIONS ON INSTRUMENTATION AND MEASUREMENT, Bd. 38, Nr. 6, 1.Dezember 1989, Seiten 1080-1082, XP000095935 DERAC SON ET AL: "A NEW CURRENT SENSOR BASED ON THE MEASUREMENT OF THE APPARENT COERCIVE FIELD STRENGTH"

## Beschreibung

Die Erfindung betrifft einen Stromsensor mit einem weichmagnetischen Magnetkern, auf dem neben einer Primärwicklung, in der der zu messende Strom fließt, eine Sekundärwicklung aufgewickelt ist, in die ein Wechselstrom eingespeist ist, der den Magnetkern abwechselnd in mindestens einer Richtung sättigt, und mit einer Auswerteschaltung, die den durch die Primärwicklung erzeugten Fluß in dem Magnetkern bestimmt, wobei der Magnetkern aus einem Material mit flacher Magnetisierungskurve besteht, und der durch die Sekundärwicklung fließende Wechselstrom durch eine im wesentlichen sägezahnförmige Wechselspannung erzeugt wird, wobei in einer Auswerteschaltung die positiven und negativen Stromspitzen durch die Sekundärwicklung miteinander verglichen und einem Verstärker zugeführt werden, dessen Ausgang über die Sekundärwicklung einen Kompensationsstrom fließen läßt.

Aus der EP-A-0 427 412 ist ein derartiger Stromsensor bekannt, bei dem eine Primärwicklung in einem Ringkern einen magnetischen Fluß erzeugt. Um die Größe des magnetischen Flusses und damit die Stärke des durch die Primärwicklung fließenden Stromes zu bestimmen, wird eine auf dem Ringkern aufgewickelte Sekundärwicklung mit einem bipolaren Spannungssignal beaufschlagt, das je nach vorhandener Vormagnetisierung des Ringkerns diesen mehr oder weniger schnell mit wechselnder Polarität in die Sättigung treibt. Die dabei auftretenden Spannungssignale werden von einer Auswerteschaltung ausgewertet, die zur Erzeugung eine Kompensationssignals einen Regler steuert. Das vom Regler erzeugte Kompensationssignal beaufschlagt schließlich einen Addierer, der das Kompensationssignal zum Meßsignal hinzuaddiert, so daß der magnetische Fluß im Ringbandkern zu Null kompensiert wird.

Die bekannte Meßvorrichtung eignet sich für Ströme mit Stromstärken im Bereich von wenigen mA. Bei größeren Stromstärken stößt die bekannte Meßvorrichtung jedoch schnell an ihre Grenzen, denn zur Erzeugung großer Kompensationsströme ist entweder ein großes Ausgangssignal des Addierers oder ein niederohmiger Widerstand erforderlich. In letzterem Fall wäre jedoch die Ausgangsstufe des Addierers nicht gegen plötzlich auftretende Spitzenspannungen geschützt, die aufgrund von sprungartigen Flußänderungen im Ringkern entstehen.

Ausgehend von diesem Stand der Technik liegt der Erfindung die Aufgabe zugrunde, eine einfach aufgebaute Meßvorrichtung zu schaffen, die sich zur Messung von größeren Strömen eignet.

Diese Aufgabe wird erfindungsgemäß durch einen Stromsensor nach Anspruch 1 gelöst. Weitere Vorteile ergeben sich aus der detaillierten Beschreibung.

Eine vorteilhafte Weiterbildung ist Gegenstand des abhängigen Anspruchs.
- Fig. 1: zeigt einen herkömmlichen Stromsensor im Blockschaltbild;
- Fig. 2: zeigt eine Erweiterung der in Fig. 1 dargestellten Schaltung, um eine nur positive oder nur negative Referenzspannung gegen Masse zu erzeugen;
- Fig. 3: zeigt ein Ausführungsbeispiel des erfindungsgemäßen Stromsensors, bei dem man mit zwei Wicklungen für den Magnetkern auskommt.

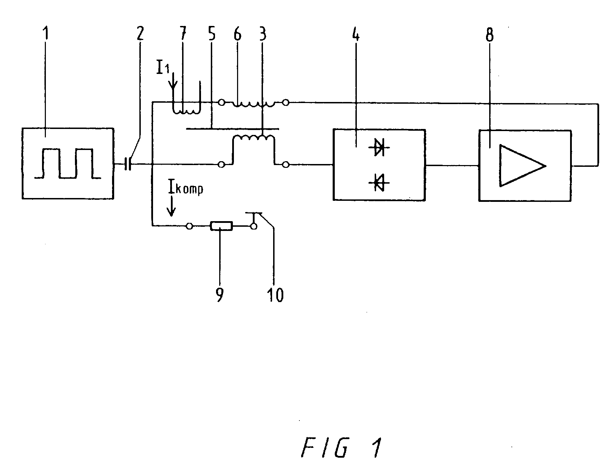

In Fig. 1 ist ein Rechteckspannungsgenerator 1 dargestellt, der über einen Reihenkondensator 2 und die Sekundärwicklung 3 an eine Auswerteschaltung 4 angeschlossen ist. Die Sekundärwicklung 3 ist auf einen weichmagnetischen Magnetkern 5 aufgewickelt, auf dem sich außerdem eine Kompensationswicklung 6 und eine Primärwicklung 7 befinden. Die Auswerteschaltung 4 ist so aufgebaut, daß sie die positiven bzw. negativen Stromspitzen, die durch die Sekundärwicklung 3 fließen, erfaßt und dem Eingang des nachgeschalteten Verstärkers 8 eine Spannung liefert, die dem Mittelwert der positiven und negativen Stromspitzen entspricht.

Der weichmagnetische Magnetkern 5 hat eine flache Magnetisierungskennlinie, d. h. eine Magnetisierungskennlinie, bei der die Induktion über einen weiten Bereich nahezu linear mit der Feldstärke zunimmt. Eine solche Magnetisierungskennlinie kann man bei weichmagnetischen Materialien insbesondere durch Temperung im Querfeld erzeugen.

Der Rechteckspannungsgenerator 1 liefert nun über den Reihenkondensator 2 eine sägezahnförmige Spannung an der Sekundärwicklung 3, die einen Wechselstrom relativ hoher Frequenz in der Sekundärwicklung erzeugt. Die Schaltung ist so gewählt, daß dieser Strom in der Sekundärwicklung ausreicht, den weichmagnetischen Magnetkern abwechselnd in die positive bzw. negative Sättigung zu treiben.

Wenn durch die anderen Wicklungen auf dem Magnetkern 5 kein Strom fließt, so sind sowohl die positiven als auch die negativen Stromspitzen durch die Sekundärwicklung 3 gleich groß.

Bei fließendem, zu messenden Strom in der Primärwicklung 7 des weichmagnetischen Magnetkerns 5 wird dieser jedoch vormagnetisiert, so daß der entstehende Wechselstrom in der Sekundärwicklung 3 beispielsweise in positiver Richtung den Magnetkern schneller in die Sättigung treibt, als in negativer Richtung. Bei umgekehrter Vormagnetisierung durch einen umgekehrten Strom in der Primärwicklung 7 wird ein positiver Strom in der Sekundärwicklung 3 später und ein negativer früher zur Sättigung des Magnetkerns 5 führen. Hierdurch entstehen in beiden Halbwellen unterschiedliche Stromspitzen in der Sekundärwicklung 3.

Eine Auswerteschaltung 4 erfaßt nun mit den angedeuteten antiparallel geschalteten Dioden sowohl den Wert für den positiven als auch negativen Spitzenstrom und bildet daraus einen Mittelwert. Dieser Mittelwert ist im wesentlichen proportional zur Vormagnetisierung des Magnetkerns 5 und damit proportional zum zu messenden Strom in der Primärwicklung 7. Der Ausgang der Auswerteschaltung 4 ist an einen Verstärker 8 angeschlossen, dessen Ausgang wiederum treibt einen Strom durch die Kompensationswicklung 6, die sich ebenfalls auf dem weichmagnetischen Magnetkern 5 befindet. Ferner ist in Reihe zu der Kompensationswicklung 6 noch ein Widerstand 9 eingeschaltet, der mit seinem zweiten Anschluß an Masse 10 liegt. An diesem Widerstand tritt nun ein Spannungsabfall auf, der dem Strom in der Kompensationswicklung 6 und damit auch dem Strom in der Primärwicklung 7 des weichmagnetischen Magnetkerns 5 proportional ist. Diese Proportionalität ergibt sich, da die Auswerteschaltung 4 mit dem nachgeschalteten Verstärker 8 den Kompensationsstrom jeweils so steuert, daß der Mittelwert der positiven und negativen Stromspitzen gleich Null ist, so daß im Magnetkern 5 keine Vormagnetisierung herrscht.

Dieser Stromsensor hat den Vorteil, daß auch größere Ströme einwandfrei gemessen werden können, da keine Sättigung des Magnetkerns 5 durch den Primärstrom erfolgt. Darüberhinaus können auch relativ schnelle Stromänderungen erfaßt werden, da der Magnetkern eine flache Magnetisierungskennlinie besitzt und so bei plötzlichen Änderungen des Primärstromes - wenn der Kompensationsstrom noch nicht angepaßt ist - nicht gleich in Sättigung geht. Die damit ansteigende Mittelwertspannung setzt die Auswerteschaltung 4 in die Lage, den Kompensationsstrom schnell nachzuführen.

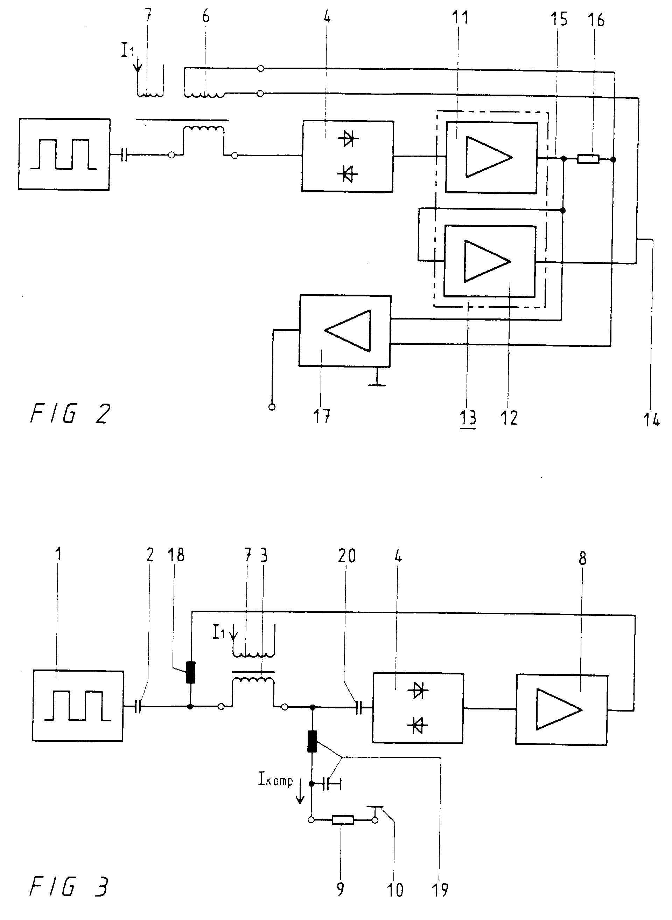

Am Widerstand 9 tritt damit eine dem zu messenden Primärstrom in der Primärwicklung 7 proportionale Spannung auf, die allerdings in der Polarität gegenüber Masse 10 von der Richtung des Stromes in der Primärwicklung 7 abhängt. Wenn man nun eine Referenzspannung haben möchte, die zur Auswertung in digitalen Anzeige- oder Regeleinrichtungen besonders geeignet ist, so ist es wünschenswert, eine Spannung zu haben, die nur eine Polarität (plus oder minus) gegenüber Masse aufweist. Hierzu ist es möglich, anstelle des Verstärkers 8 ein aus zwei Verstärkern 11 und 12 gebildete Brückenverstärkeranordnung 13 einzusetzen, deren Ausgänge 14 und 15 an die Anschlüsse der Kompensationswicklung 6 angeschlossen sind (s. Fig. 2). Hierdurch entsteht an dem Widerstand 16 eine Spannung, die über einen zusätzlichen Verstärker 17 verstärkt werden kann und unabhängig von der Richtung des zu messenden Stromes in der Primärwicklung 7 jeweils nur einen positiven oder einen negativen Wert gegenüber Masse 10 aufweist.

In Fig. 3 ist eine Anordnung nach der Erfindung dargestellt, bei der man ohne die Kompensationswicklung 6 auskommt. Die Anordnung ist im wesentlichen ähnlich derjenigen nach Fig. 1 mit dem Unterschied, daß der Ausgang des Verstärkers 8 über einen Tiefpaß, z. B. als Tiefpaß wirkende Induktivität 18, an den zum Rechteckspannungsgenerator führenden Anschluß der Sekundärwicklung 3 angeschlossen ist. Der Kompensationsstrom fließt dann ebenfalls über die Sekundärwicklung 3 und von dort über einen Tiefpaß, z. B. einen aus Induktivität und Kapazität bestehenden Tiefpaß, und über den Widerstand 9 zur Masse 10. Um den niederfrequenten Kompensationsstrom von der Auswerteschaltung 4 fernzuhalten, ist ein Hochpaß, z. B. zwischen diese und den Tiefpaß 19 ein weiterer Kondensator 20, eingeschaltet.

## Patentansprüche

1. Stromsensor mit einem weichmagnetischen Magnetkern (5), auf dem neben einer Primärwicklung (7), in der der zu messende Strom fließt, eine Sekundärwicklung (3) aufgewickelt ist, in die ein Wechselstrom eingespeist ist, der den Magnetkern abwechselnd in mindestens einer Richtung sättigt, und mit einer Auswerteschaltung (4), die den durch die Primärwicklung erzeugten Fluß in dem Magnetkern (5) bestimmt, wobei der Magnetkern (5) aus einem Material mit flacher Magnetisierungskurve besteht, und der durch die Sekundärwicklung (3) fließende Wechselstrom durch eine im wesentlichen sägezahnförmige Wechselspannung erzeugt wird, wobei in der Auswerteschaltung (4) die positiven und negativen Stromspitzen der durch die Sekundärwicklung (3) fließenden Wechselstromen miteinander verglichen und dann einem Verstärker (8) zugeführt werden, dessen Ausgang über die Sekundärwicklung (3) einen Kompensationsstrom fließen läßt,
**dadurch gekennzeichnet**,
daß der Wechselstrom über Hochpaßfilter (2, 20) in die Sekundärwicklung (3) eingekoppelt ist, während der Kompensationsstrom über zwischen der Sekundärwicklung (3) und den Hochpaßfiltern (2, 20) an die Sekundärwicklung (3) angeschlossene Tiefpaßfilter (18, 19) in die Sekundärwicklung (3) eingekoppelt ist.

2. Stromsensor nach Anspruch 1,
**dadurch gekennzeichnet**,
daß zur Anpassung an Regel- oder Anzeigeeinrichtungen mit digitaler Auswertung eine Brückenverstärkeranordnung (13) der Auswerteschaltung (4) nachgeschaltet ist, die aus der Ausgangsspannung der Auswerteschaltung (4), deren Polarität abhängig von der Richtung des zu messenden Primärstromes in der Primärwicklung (7) ist, eine Referenzspannung erzeugt, die gegenüber Masse nur einen positiven bzw. einen negativen Wert hat.

## Claims

1. Current sensor having a soft-magnetic magnet core (5) on which, in addition to a primary winding (7) in which the current to be measured flows, a secondary winding (3) is wound, into which an alternating current is fed which saturates the magnet core alternately in at least one direction, and having an evaluation circuit (4) which determines the flux produced in the magnet core (5) by the primary winding, with the magnet core (5) being composed of a material having a flat magnetization curve, and the alternating current flowing through the secondary winding (3) being produced by an essentially sawtooth-waveform AC voltage, with the positive and negative current peaks of the alternating current flowing through the secondary winding (3) being compared with one another in the evaluation circuit (4) and then being supplied to an amplifier (8) whose output causes a compensation current to flow via the secondary winding (3), characterized in that the alternating current is coupled via high-pass filters (2, 20) to the secondary winding (3), while the compensation flow is coupled to the secondary winding (3) via low-pass filters (18, 19), which are connected to the secondary winding (3) between the secondary winding (3) and the high-pass filters (2, 20).

2. Current sensor according to Claim 1, characterized in that a bridge amplifier arrangement (13) is connected downstream of the evaluation circuit (4) for matching to control or display devices having digital evaluation, and produces from the output voltage of the evaluation circuit (4), whose polarity depends on the direction of the primary current to be measured in the primary winding (7), a reference voltage which has only a positive or a negative value with respect to earth.

## Revendications

1. Capteur de courant à noyau (5) magnétique en matériau magnétique doux, sur lequel est enroulé à côté d'un enroulement (7) primaire, dans lequel passe le courant à mesurer, un enroulement (3) secondaire, qui est alimenté en un courant alternatif qui sature le noyau magnétique alternativement dans au moins une direction, et à circuit (4) d'exploitation, qui détermine le flux produit par l'enroulement primaire dans le noyau (5) magnétique, le noyau (5) magnétique étant en un matériau à courbe d'aimantation plate, et le courant alternatif passant dans l'enroulement (3) secondaire étant produit par une tension alternative sensiblement en dents de scie, les pics de courant positifs et négatifs du courant alternatif passant dans l'enroulement (3) secondaire étant comparés les uns aux autres dans le circuit (4) d'exploitation et ensuite envoyés à un amplificateur (8) dont la sortie fait passer un courant de compensation par l'intermédiaire de l'enroulement (3) secondaire,
caractérisé en ce que
le courant alternatif est injecté dans l'enroulement (3) secondaire par l'intermédiaire de filtres (2,20) passe haut, tandis que le courant de compensation est injecté dans l'enroulement (3) secondaire par l'intermédiaire de filtres (18,19) passe bas, raccordés à l'enroulement (3) secondaire entre l'enroulement (3) secondaire et les filtres (2,20) passe haut.

2. Capteur de courant suivant la revendication 1,
caractérisé en ce que,
pour l'adaptation à des dispositifs de régulation et/ou d'affichage à exploitation numérique, il est monté en aval du circuit (4) d'exploitation un dispositif (13) amplificateur en pont, qui produit à partir de la tension de sortie du circuit (4) d'exploitation dont la polarité dépend du sens du courant primaire à mesurer dans l'enroulement (7) primaire, une tension de référence qui a une valeur seulement positive ou seulement négative par rapport à la masse.
